# EUROPÄISCHE PATENTANMELDUNG

(11) **EP 2 056 357 A2**
(43) Veröffentlichungstag der Anmeldung: **06.05.2009**
(21) Anmeldenummer: 08167953.2
(22) Anmeldetag: 30.10.2008
(51) Int. Cl.: H01L 31/042, H01L 31/02

(54) **Anordnung mit einem Solarzellenmodul und einem Rahmen**

(30) Priorität: 02.11.2007 DE 102007052722
(71) Anmelder: Günther Spelsberg GmbH & Co. KG, 58579 Schalksmühle (DE)
(72) Erfinder: Spelsberg, Holger, 58579, Schalskmühle (DE)
(74) Vertreter: Schulz, Dirk

(57) **Zusammenfassung**

Die Erfindung betrifft eine Anordnung mit einem Solarzellenmodul 1 und einem Rahmen 3, wobei das Solarzellenmodul 1 eine Mehrzahl von Solarzellen 2 aufweist, die in einer Mehrzahl von elektrischen Reihenschaltungen angeordnet sind, und wobei der Rahmen 3 das Solarzellerunodul 1 wenigstens teilweise umgibt. Erfindungsgemäß ist im Rahmen eine Verbindungseinrichtung 7 zur elektrischen Verbindung zwischen zwei Reihenschaltungen vorgesehen. Damit wird eine Möglichkeit anzugeben, einen einfachen und sicheren Anschluss von einer Mehrzahl elektrisch in Reihe geschalteten Solarzellen eines Solarzellenmoduls zu gewährleisten.

## Beschreibung

Die Erfindung betrifft eine Anordnung mit einem Solarzellenmodul und einem Rahmen, wobei das Solarzellenmodul eine Mehrzahl von Solarzellen aufweist, die in einer Mehrzahl von elektrischen Reihenschaltungen angeordnet sind, und wobei der Rahmen das Solarzellenmodul wenigstens teilweise umgibt.

Für Photovoltaik-Anlagen wird im Allgemeinen eine Mehrzahl von Solarzellenmodulen verwendet, wobei ein jedes Solarzellenmodul aus einer Mehrzahl von Solarzellen aufgebaut ist. Für ein jeweiliges Solarzellenmodul sind die einzelnen Solarzellen aufgrund ihrer geringen Einzelleistung in der Regel in Reihe geschaltet. Dazu werden die Frontseitenkontakte einer Solarzelle mit den Rückseitenkontakten der nächsten Solarzelle kontaktiert. Dadurch erhält man eine Reihenschaltung der Solarzellen, da jeweils der Minuspol auf der Vorderseite der einen Solarzelle mit dem Pluspol auf der Rückseite der folgenden Solarzelle verbunden wird. Der eigentliche elektrische Anschluss des Solarzellenmoduls erfolgt dann über die Kontakte der ersten bzw. letzten Solarzelle in der Reihenschaltung des Solarzellenmoduls.

Die Kontakte der Solarzellen, auch als Strings oder Ribbons bezeichnet, werden zum elektrischen Anschluss bisher aus dem Solarzellenmodul herausgeführt, typischerweise nämlich auf dessen Rückseite, indem eine dort vorgesehene Schutzschicht, im Allgemeinen in Form einer Schutzfolie, partiell geöffnet wird, so dass die Kontakte hindurchgeführt werden können. Die Kontakte werden dann in der Regel in eine Anschlussdose hineingeführt, die im Allgemeinen in wasserdichter Weise auf die Rückseite des Solarzellenmoduls aufgeklebt ist. Diese Vorgehensweise ist mit großem Aufwand verbunden und darüber hinaus fehleranfällig. Insbesondere kann nämlich nicht immer auf sichere Weise ausgeschlossen werden, dass an der Stelle, an der die Kontakte der Solarzellen aus dem Solarzellenmodul herausgeführt sind, kein Wasser eindringt oder es zu sonstigen Beschädigungen kommt. Ferner ist die Kontaktierung und Installation in der Anschlussdose aufwendig und mitunter schwierig.

Vor diesem Hintergrund ist es die Aufgabe der Erfindung, eine Möglichkeit anzugeben, einen einfachen und sicheren Anschluss von einer Mehrzahl elektrisch in Reihe geschalteten Solarzellen eines Solarzellenmoduls zu ermöglichen.

Ausgehend von der eingangs beschriebenen Anordnung ist diese Aufgabe dadurch gelöst, dass im Rahmen eine Verbindungseinrichtung zur elektrischen Verbindung zwischen zwei Reihenschaltungen vorgesehen ist.

Solarzellenmodule werden häufig als gerahmte Module eingesetzt, typischerweise nämlich mit einem den Umfang des Solarzellenmoduls vollständig umgebenden Rahmen, der z.B. aus einem Metall, wie Aluminium, hergestellt ist. Diese Vorgehensweise dient insbesondere einer einfachen und universellen sowie sicheren Einsetzbarkeit des Solarzellenmoduls, da aufgrund des Rahmens eine verbesserte mechanische Stabilität, insbesondere im Hinblick auf die Biegesteifigkeit des Solarzellenmoduls, erzielt wird.

Erfindungsgemäß ist nun vorgesehen, den bisher nur zur Verbesserung der mechanischen Eigenschaften des Solarzellenmoduls eingesetzten Rahmen zusätzlich oder alternativ dahingehend zu verwenden, dass dieser eine Einrichtung für die elektrische Verbindung von zwei Reihenschaltungen von Solarzellen des Solarzellenmoduls bereitstellt. In den Rahmen integriert ist also wenigstens eine Verbindungseinrichtung, mit der bei Anbringung des Rahmens an das Solarzellenmodul zwei oder mehr Reihenschaltungen von Solarzellen elektrisch miteinander verbunden werden können. Mit anderen Worten ermöglicht die Erfindung, bei in Längsrichtung vorgesehenen Reihenschaltungen von Solarzellen die Querverbindung der Reihen von Solarzellen miteinander auf dem Solarzellenmodul selbst zu vermeiden, da eine oder mehrere entsprechende elektrische Querverbindungen im Rahmen realisiert sind.

Gemäß einer bevorzugten Weiterbildung der Erfindung ist in diesem Zusammenhang vorgesehen, dass die Umhüllung der Verbindungseinrichtung, die für die elektrische Querverbindung im Rahmen sorgt, aus einem Isolierstoff ausgeführt ist. Das heißt, dass die Verbindungseinrichtung vorzugsweise nach außen hin elektrisch isoliert ist. Weiterhin ist gemäß einer bevorzugten Weiterbildung der Erfindung vorgesehen, dass die elektrische Isolierung der Verbindungseinrichtung durch eine Einrichtung des Rahmens gewährleistet ist. Weiterhin ist der Rahmen vorzugsweise derart ausgeführt und angeordnet, dass das Solarzellenmodul mechanisch stabilisiert ist, insbesondere hinsichtlich dessen Biegesteifigkeit. Dies bedeutet, dass der Rahmen mit der erfindungsgemäß vorgesehenen Verbindungseinrichtung zur elektrischen Verbindung zwischen zwei Reihenschaltungen vorzugsweise neben seinen elektrischen Eigenschaften auch derartige mechanischen Eigenschaften aufweist, die auch schon bei herkömmlichen Rahmen für Solarzellenmodule vorgesehen gewesen sind.

Grundsätzlich kann es ausreichend sein, dass im Rahmen lediglich eine Verbindungseinrichtung zur Verbindung von zwei Reihenschaltungen vorgesehen ist. Gemäß einer bevorzugten Weiterbildung der Erfindung ist jedoch vorgesehen, dass im Rahmen eine Mehrzahl von Verbindungseinrichtungen zur Verbindung voneinander verschiedener Paare von Reihenschaltungen vorgesehen ist. Insbesondere kann auf diese Weise letztlich erreicht werden, dass alle Solarzellen des Solarzellenmoduls insgesamt in einer einzigen Reihenschaltung vorgesehen sind, vorzugsweise derart, dass sich diese Reihenschaltung mäanderförmig über die Fläche des Solarzellenmoduls erstreckt.

Es ist grundsätzlich nicht erforderlich, dass im Rahmen neben der Verbindungseinrichtung zur elektrischen Verbindung wenigstens zweier Reihenschaltungen zusätzliche Einrichtungen vorgesehen sind. Gemäß einer bevorzugten Weiterbildung der Erfindung ist jedoch vorgesehen, dass im Rahmen eine Anschlusseinrichtung für einen elektrischen Anschluss des Solarzellenmoduls vorgesehen ist. Insbesondere dient eine derartige Anschlusseinrichtung zum Anschluss des Solarzellenmoduls an einen Verbraucher oder an ein Verbrauchernetz.

Weiterhin ist gemäß einer bevorzugten Weiterbildung der Erfindung vorgesehen, dass im Rahmen wenigstens eine Schutzeinrichtung für die Solarzellen angeordnet ist, vorzugsweise in Form einer oder mehrerer Bypass-Dioden oder/und in Form wenigstens einer elektronischen Bypass-Schaltung. Im Ergebnis kann der Rahmen damit zumindest teilweise, vorzugsweise jedoch auch vollständig, diejenigen Funktionen übernehmen, die bisher von einer Anschlussdose für ein Solarzellenmodul übernommen worden sind.

Die Kontaktelemente der Solarzellen können auf unterschiedliche Weise ausgestaltet und angeordnet sein. Gemäß einer bevorzugten Weiterbildung der Erfindung ist jedoch vorgesehen, dass die Kontaktelemente der Solarzellen am Ende bzw. Anfang einer Reihenschaltung aus dem Solarzellenmodul herausgeführt sind. Insbesondere ist in diesem Zusammenhang gemäß einer bevorzugten Weiterbildung der Erfindung vorgesehen, dass die Reihenschaltungen von Solarzellen in Längsrichtung und vorzugsweise parallel zueinander angeordnet sind und die Kontaktelemente der Solarzellen an dem jeweiligen Längsende des Solarzellenmoduls, vorzugsweise aus der Stirnseite des Solarzellenmoduls, herausgeführt sind. Auf diese Weise wird eine besonders einfache Anordnung erzielt, und darüber hinaus wird eine einfache und verlässliche Anschlussmöglichkeit der Kontaktelemente ermöglicht, wie im Detail weiter unten ausgeführt.

Grundsätzlich kann es ausreichend sein, dass der Rahmen das Solarzellenmodul nur teilweise umschließt. Gemäß einer bevorzugten Weiterbildung der Erfindung ist jedoch vorgesehen, dass der Rahmen das Solarzellenmodul vollständig umschließt. Dazu kann der Rahmen insbesondere mehrteilig sein und dabei z. B. zwei einander gegenüberliegende Längsteile, zwei einander gegenüberliegende Querteile und zur Verbindung dieser Teile miteinander insgesamt vier Eckteile aufweisen, wenn das Solarzellenmodul, wie im Allgemeinen üblich, in einer rechteckigen Form ausgebildet ist.

Im Folgenden wird ein erfindungsgemäßes Solarzellenmodul mit einer Mehrzahl von Solarzellen beschrieben, die in einer Mehrzahl von elektrischen Reihenschaltungen angeordnet sind, wobei dieses Solarzellenmodul ausgestaltet sein kann, wie zuvor beschrieben, jedoch auch alternative Ausgestaltungen des Solarzellenmoduls vorgesehen sein können.

Bei einem derartigen Solarzellenmodul ist die weiter oben angegebene Aufgabe der Erfindung dadurch gelöst, dass das Kontaktelement wenigstens einer Solarzelle am Ende bzw. Anfang einer Reihenschaltung in einem Randbereich des Solarzellenmoduls aus dem Solarzellenmodul herausgeführt und dort mittels eines den Randbereich umgreifenden Federelements elektrisch kontaktiert ist.

Gemäß diesem Aspekt der Erfindung ist also ein Federelement vorgesehen, dass im Randbereich des Solarzellenmoduls eingesetzt wird und dort zur elektrischen Kontaktierung eines aus dem Solarzellenmodul herausgeführten Kontaktelements einer Solarzelle dient. Während die Kontaktierung von Kontaktelementen der Solarzellen bisher sehr aufwendig und schwierig gewesen ist, nämlich häufig von Hand in einer Anschlussdose für ein Solarzellenmodul erfolgen musste, wird damit erfindungsgemäß eine sehr einfache und insbesondere auch verlässliche Möglichkeit der elektrischen Kontaktierung angegeben.

Dabei kann das Kontaktelement an unterschiedlichen Stellen aus dem Solarzellenmodul herausgeführt sein. Gemäß einer bevorzugten Weiterbildung der Erfindung ist jedoch vorgesehen, dass das Kontaktelement an der Stirnseite des Solarzellenmoduls herausgeführt ist.

Grundsätzlich kann das Federelement unterschiedlichen geometrischen Formen folgen. Gemäß einer bevorzugten Weiterbildung der Erfindung ist jedoch vorgesehen, dass das Federelement U-förmig ausgestaltet ist und dabei vorzugsweise mit seinen beiden parallelen Schenkeln auf der Frontseite bzw. auf der Rückseite des Solarzellenmoduls aufliegt. Dies ermöglicht insbesondere, das Kontaktelement einer Solarzelle elektrisch zu kontaktieren, indem dieses mittels eines Schenkels des Federelements gegen die Front- bzw. Rückseite des Solarzellenmoduls gedrückt wird. Ist das Federelement z. B. an der Stirnseite des Solarzellenmoduls aus diesem herausgeführt, so kann das Kontaktelement längs der Stirnseite und weiter z. B. längs der Rückseite des Solarzellenmoduls umgelegt und dann mittels des Federelements auf dem Solarzellenmodul festgeklemmt werden.

Dabei kann einerseits vorgesehen sein, dass das Federelement lediglich eine mechanische Kontaktierung des Kontaktelements gewährleistet und zur elektrischen Kontaktierung des Kontaktelements ein zusätzliches Element vorgesehen ist, gegen das das Kontaktelement aufgrund der Federkraft des Federelements gedrückt wird. Gemäß einer bevorzugten Weiterbildung der Erfindung ist jedoch vorgesehen, dass das Kontaktelement selbst zur elektrischen Kontaktierung dient. Gemäß einer bevorzugten Weiterbildung der Erfindung ist in diesem Zusammenhang insbesondere vorgesehen, dass das Federelement einen metallischen Abschnitt aufweist, vorzugsweise vollständig aus Metall hergestellt ist.

Wie zuvor schon ausgeführt, ist die Lösung mit dem Federelement zur Kontaktierung des Kontaktelements einer Solarzelle insbesondere bei einem Solarzellenmodul mit einem Rahmen, wie weiter oben beschrieben, einsetzbar. Insofern ist gemäß einer bevorzugten Weiterbildung der Erfindung vorgesehen, dass ein das Solarzellenmodul wenigstens teilweise umgebender Rahmen vorgesehen ist, im Rahmen einer Verbindungseinrichtung zur elektrischen Verbindung von zwei verschiedenen Reihenschaltungen vorgesehen ist und die Verbindungseinrichtung das Federelement aufweist.

Dabei kann es grundsätzlich ausreichend sein, dass lediglich ein Federelement vorgesehen ist. Gemäß einer bevorzugten Weiterbildung der Erfindung ist jedoch vorgesehen, dass eine Mehrzahl von Federelementen vorgesehen ist, so dass eine Mehrzahl von Paaren von Reihenschaltungen miteinander elektrisch kontaktiert werden können.

Die Erfindung wird nachfolgend unter Bezugnahme auf ein bevorzugtes Ausführungsbeispiel der Erfindung anhand der Zeichnung weiter im Detail erläutert. In der Zeichnung zeigen:
- Fig. 1: schematisch eine Anordnung mit einem Solarzellenmodul und einem Rahmen gemäß einem bevorzugten Ausführungsbeispiel der Erfindung in Draufsicht, und
- Fig. 2: die Kontaktierung eines Kontaktelements mit einem Federelement gemäß dem bevorzugten Ausführungsbeispiel der Erfindung in einer Schnittdarstellung.

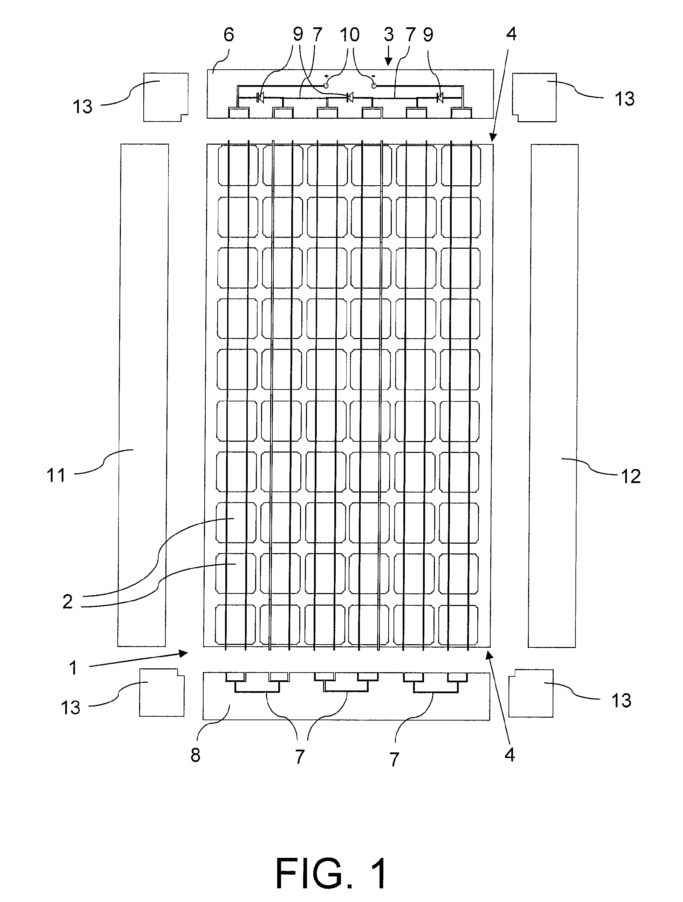

Aus Figur 1 ist schematisch in Draufsicht ein Solarzellenmodul 1 mit einer Mehrzahl von Solarzellen 2 und einem zugehörigen Rahmen 3 ersichtlich. Die Solarzellen 2 des Solarzellenmoduls 1 sind in sechs zueinander parallelen Reihen angeordnet und in diesen jeweils elektrisch in Reihe verschaltet, indem die Kontaktelemente auf der Frontseite einer jeweiligen Solarzelle 2 mit den Kontaktelementen auf der Rückseite der nächsten Solarzelle 2 verlötet sind. An den Stirnseiten 4 des Solarzellenmoduls 1 sind die Kontaktelemente 5 der randseitigen Solarzellen 2 jeweils aus dem Solarzellenmodul 1 herausgeführt.

In den stirnseitig vorgesehenen Querelementen 6, 8 des Rahmens 3 sind nun jeweils Verbindungseinrichtungen 7 zur elektrischen Verbindung von jeweils zwei einander benachbarten Reihen von Solarzellen 2 vorgesehen. Mittels dieser Verbindungseinrichtungen 7 des Rahmens 3 wird damit insgesamt eine einzige Reihenschaltung aller Solarzellen 2 des Solarzellenmoduls 1 erzielt, nämlich derart, dass sich diese Reihenschaltung mäanderförmig über die gesamte Fläche des Solarzellenmoduls 1 erstreckt.

Außer den Verbindungseinrichtungen 7, die sowohl im in Figur 1 oben dargestellten Querelement 6 als auch im unteren Querelement 8 vorgesehen sind, sind im oberen Querelement 6 zusätzliche Einrichtungen vorgesehen, nämlich drei Schutzeinrichtungen 9 in Form von Bypass-Dioden, die zur Absicherung der Solarzellen 2 in bekannter Weise dienen, und eine Anschlusseinrichtung 10 für einen elektrischen Anschluss des Solarzellenmoduls an z. B. ein nicht weiter dargestelltes Verbrauchernetz.

Insgesamt weist der Rahmen 3 zusätzlich zu den beiden Querelementen weitere Bestandteile auf, nämlich ein linkes Längselement 11 und ein rechtes Längselement 12 sowie vier Eckteile 13 zur Verbindung der Querelemente 6, 8 mit den Längselementen 11, 12. Insgesamt wird damit ein mechanisch stabiler Rahmen 3 erzielt, der die mechanische Stabilität des Solarzellenmoduls 1 deutlich verbessert, insbesondere hinsichtlich dessen Biegesteifigkeit.

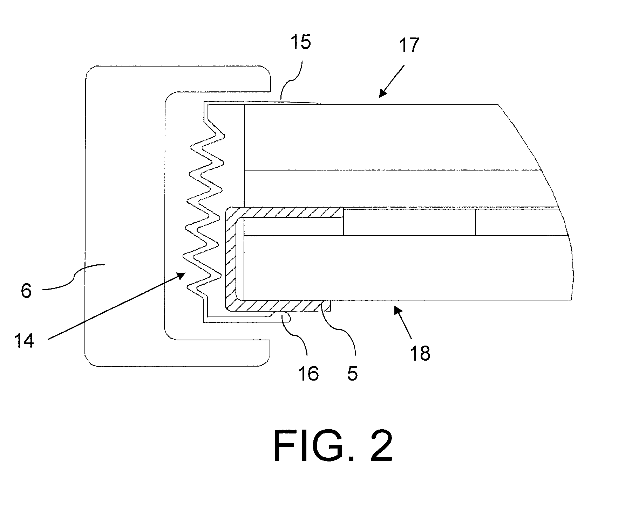

Aus Figur 2 ist nun eine Schnittdarstellung ersichtlich, die zeigt, wie die Kontaktierung der aus der Stirnseite 4 des Solarzellenmoduls 1 herausgeführten Kontaktelemente 5 der Solarzellen 2 gemäß dem vorliegend beschriebenen bevorzugten Ausführungsbeispiel der Erfindung erfolgt. Wie aus Figur 2 ersichtlich, ist das aus der Stirnseite 4 des Solarzellenmoduls 1 herausgeführte Kontaktelement 5 zuerst längs der Stirnseite und dann weiter längs der Rückseite des Solarzellenmoduls umgelegt, wobei zur elektrischen Kontaktierung des Kontaktelements 5 ein Federelement 14 aus Metall vorgesehen ist. Dieses Federelement 14 ist im Wesentlichen U-förmig, wobei es mit seinen beiden parallel zueinander verlaufenden Schenkeln 15, 16 auf der Frontseite 17 bzw. auf der Rückseite 18 des Solarzellenmoduls 1 aufliegt. Auf der Rückseite 18 liegt das Federelement 14 jedoch nicht direkt auf, sondern klemmt dort das wie zuvor beschrieben umgelegte, aus der Stirnseite 4 des Solarzellenmoduls 1 herausgeführte Kontaktelement.

Wie ebenfalls aus Figur 2 ersichtlich, ist das Federelement 14 innerhalb des Querelements 6 des Rahmens 3 vorgesehen. Da der Rahmen 3 und insbesondere auch das Querelement 6 des Rahmens 3 gemäß dem vorliegend beschriebenen bevorzugten Ausführungsbeispiel der Erfindung aus einem isolierenden Material, insbesondere nämlich aus einem Kunststoff, hergestellt ist, wird auf diese Weise auch eine elektrische Isolierung des Federelements 14 und damit eine elektrische Isolierung der Kontaktierung der Reihenschaltungen der Solarzellen 2 des Solarzellenmoduls 1 miteinander erzielt.

Im Ergebnis wird somit auf einfache und verlässliche Weise eine Kontaktierung der aus dem Solarzellenmodul 1 herausgeführten Kontaktelemente 5 der Solarzellen 2 ermöglicht, ohne aufwendige Installationsarbeiten innerhalb eines separat vorgesehenen Anschlussdose für das Solarzellenmodul 1 durchführen zu müssen. Der vorliegend vorgesehene Rahmen 3 dient nämlich einerseits zur mechanischen Stabilisierung des Solarzellenmoduls 1, gewährleistet jedoch andererseits auch die elektrische Kontaktierung der Solarzellen 2 des Solarzellenmoduls 1 untereinander sowie deren elektrische Absicherung mittels Bypass-Dioden sowie den elektrischen Anschluss des Solarzellenmoduls 1 insgesamt.

## Patentansprüche

1. Solarzellenmodul, mit einer Mehrzahl von Kontaktelemente (5) aufweisenden Solarzellen (2), die in einer Mehrzahl von elektrischen Reihenschaltungen angeordnet sind, **dadurch gekennzeichnet, dass** ein Kontaktelement (5) wenigstens einer Solarzelle (2) am Ende bzw. Anfang einer Reihenschaltung in einem Randbereich des Solarzellenmoduls (1) aus dem Solarzellenmodul (1) herausgeführt und dort mittels eines den Randbereich umgreifenden Federelements (14) elektrisch kontaktiert ist.

2. Solarzellenmodul nach Anspruch 1, **dadurch gekennzeichnet, dass** das Kontaktelement (5) an der Stirnseite des Solarzellenmoduls (1) aus diesem herausgeführt ist.

3. Solarzellenmodul nach Anspruch 1 oder 2, **dadurch gekennzeichnet, dass** das Federelement (14) U-förmig ist und mit seinen beiden parallelen Schenkeln (15, 16) auf der Frontseite (17) bzw. auf der Rückseite (18) des Solarzellenmoduls (1) aufliegt.

4. Solarzellenmodul nach Anspruch 3, **dadurch gekennzeichnet, dass** das Kontaktelement (5) der Solarzelle (2) mittels eines Schenkels (16) kontaktiert wird.

5. Solarzellenmodul nach einem der Ansprüche 1 bis 4, **dadurch gekennzeichnet, dass** ein das Solarzellenmodul (1) wenigstens teilweise umgebender Rahmen (3) vorgesehen ist, im Rahmen (3) eine Verbindungseinrichtung (7) zur elektrischen Verbindung von zwei verschiedenen Reihenschaltungen vorgesehen ist und die Verbindungseinrichtung (7) das Federelement (14) aufweist.

6. Solarzellenmodul nach einem der Ansprüche 1 bis 5, **dadurch gekennzeichnet, dass** eine Mehrzahl von Federelementen (14) vorgesehen ist.

7. Solarzellenmodul nach einem der Ansprüche 1 bis 6, **dadurch gekennzeichnet, dass** das Federelement (14) metallisch ist.

8. Anordnung mit einem Solarzellenmodul (1) und einem Rahmen (3), wobei das Solarzellenmodul (1) eine Mehrzahl von Solarzellen (2) aufweist, die in einer Mehrzahl von elektrischen Reihenschaltungen angeordnet sind, und wobei der Rahmen (3) das Solarzellenmodul (1) wenigstens teilweise umgibt, **dadurch gekennzeichnet, dass** im Rahmen (3) eine Verbindungseinrichtung (7) zur elektrischen Verbindung von zwei Reihenschaltungen vorgesehen ist.

9. Anordnung nach Anspruch 8, **dadurch gekennzeichnet, dass** die Verbindungseinrichtung (7) nach außen hin elektrisch isoliert ist.

10. Anordnung nach Anspruch 8 oder 9, **dadurch gekennzeichnet, dass** die elektrische Isolierung der Verbindungseinrichtung (7) durch eine Einrichtung des Rahmens (3) gewährleistet ist.

11. Anordnung nach einem der Ansprüche 8 bis 10, **dadurch gekennzeichnet, dass** der Rahmen (3) derart ausgeführt und angeordnet ist, dass das Solarzellenmodul (1) mechanisch stabilisiert ist, insbesondere hinsichtlich seiner Biegesteifigkeit.

12. Anordnung nach einem der Ansprüche 8 bis 11, **dadurch gekennzeichnet, dass** im Rahmen (3) eine Mehrzahl von Verbindungseinrichtungen (7) zur Verbindung voneinander verschiedener Paare von Reihenschaltungen vorgesehen ist.

13. Anordnung nach einem der Ansprüche 8 bis 12, **dadurch gekennzeichnet, dass** im Rahmen (3) eine Anschlusseinrichtung (10) für einen elektrischen Anschluss des Solarzellenmoduls (1) vorgesehen ist.

14. Anordnung nach einem der Ansprüche 8 bis 13, **dadurch gekennzeichnet, dass** im Rahmen (3) wenigstens eine Schutzeinrichtung (9) für die Solarzellen (2), vorzugsweise eine Bypass-Diode oder/und eine elektronische Bypass-Schaltung, vorgesehen ist.

15. Anordnung nach einem der Ansprüche 8 bis 14, **dadurch gekennzeichnet, dass** die Kontaktelemente (5) der Solarzellen (2) am Ende bzw. Anfang einer Reihenschaltung aus dem Solarzellenmodul (1) herausgeführt sind.
